(19) Europäisches Patentamt
European Patent Office
Office européen des brevets

(11) EP 2 878 927 B1

(12) **EUROPEAN PATENT SPECIFICATION**

(45) Date of publication and mention
of the grant of the patent:
**26.10.2016 Bulletin 2016/43**

(51) Int Cl.:
**G01D 5/16** $^{(2006.01)}$         **H03F 3/16** $^{(2006.01)}$

(21) Application number: **13195129.5**

(22) Date of filing: **29.11.2013**

(54) **Sensor circuit for measuring a physical quantity**

Sensorschaltung zur Messung einer physikalischen Größe

Circuit de détection destiné à mesurer une quantité physique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**03.06.2015 Bulletin 2015/23**

(73) Proprietor: **Fraunhofer-Gesellschaft zur
Förderung der
angewandten Forschung e.V.
80686 München (DE)**

(72) Inventors:
• **Nikas, Antonios
91054 Erlangen (DE)**

• **Leman, Olivier
91056 Erlangen (DE)**
• **Hauer, Johann
91058 Erlangen (DE)**

(74) Representative: **Zinkler, Franz et al
Schoppe, Zimmermann, Stöckeler
Zinkler, Schenk & Partner mbB
Patentanwälte
Radlkoferstrasse 2
81373 München (DE)**

(56) References cited:
**WO-A1-80/01527      US-A- 3 953 808
US-A- 4 247 824      US-A- 5 444 579**

**Description**

The present invention relates to a sensor circuit for measuring a physical quantity. In particular the present invention relates to a sensor circuit comprising a variable resistor having a resistance depending on the physical quantity.

Micro-electro-mechanical system based sensors (MEMS based sensors) are becoming more and more common in everyday live, usually in medical or consumer portable devices. Power consumption and area of such devices is critical and needs to be reduced while keeping high performance measurements. Therefore new sensor readout concepts are needed. Resistive sensors are well suited for technological downscaling reaching the nanometer range, while keeping a high signal-to-noise-ratio (SNR). One drawback of such devices is the need of a constant biasing current for signal recovery.

In "Practical design techniques for sensor signal conditioning", Walt Kester, Analog Devices 1999, standard circuits are discussed. In such standard off-the-shelf solutions usually use variable resistors in a Wheatstone bridge configuration. High supply voltages allow high dynamic range. Power consumption and area are usually not an issue. Figure 2.7 and 2.8 of the reference show the most common solution for the readout circuit. Major drawback for low power solution is the need to bias the amplifier and the sensor separately.

US Patent Application Publication US 2011/0248783 A1 discloses a circuit for amplifying a signal representing a variation in resistance of a variable resistance and a corresponding sensor. Here, a common-gate configuration with a sensor resistor connected to the source of the amplifying MOS transistor is used. The circuit comprises two current branches. A first current branch is biasing the sensor and copying the sensor signal to the amplification stage and a second current branch is voltage biased by the first branch and provides amplification of the input signal. Half of the power consumption is used to copy the input signal. The noise of the biasing circuit is added directly to one of the inputs. The circuit is configured with a single-ended output. It is designed to be operated as a continuous-time open-loop system. However, the offsets (sensor, MOS) induce system saturation because of the high not well defined gain. To allow for correct system operation, offset trimming solutions are proposed. As an example, offset-trimming may be done by adjunction of a current-mode digital-to-analog converter (DAC). The circuit is configured as a loop filter element including pulsed feedback means for Sigma-Delta modulator implementation, for both sensor signal analog-to-digital conversion and offset compensation.

US Patent 6,724,202 B2 discloses a physical quantity detection device with temperature compensation. It comprises two operational amplifiers. Simultaneous compensation of both the TCR and the TCS of a piezoresistive sensor by selection of the doping of a feedback resistance (Rts) so as to tune its temperature characteristic is proposed. Reference voltage is the supply voltage, sensor output voltage is proportional the supply voltage. The circuit comprises an offset and offset temperature characteristic compensation circuit, which has a single-ended output. Mathematical analysis of the temperature compensation principles is done. The system has a non-linear characteristic with respect to the variations in resistance, whereas a basic push-pull Wheatstone bridge without feedback has a linear characteristic. So in the proposed system the feedback induces a non-linearity.

Furthermore, US Patent 4,786,993 shows a voltage amplifier for constant voltage biasing and amplifying signals from a magnetoresistive sensor (MR sensor). The MR sensor is biased and its signal is amplified. One MR detector is connected between the inputs of the amplifier. Feedback of the voltage is done across the sensor. The circuit has a fully differential output. The sensor bias point is defined by the emitter resistor RE. In the bloc diagram schematics there is no description of the common-mode feedback provided.

US Patent 7,961,418 B2 describes resistivity sense bias circuit and methods of operating the same. Disclosed is a MR hard drive readout. The magnetoresistive detector is biased at the constant voltage with an resistor Rp. Common base bipolar transistors operated at the same collector current are used for magnetoresistive signal amplification.

It's an object of the present invention two provide an improved sensor circuit for measuring a physical quantity.

The objective is achieved by a sensor circuit for measuring a physical quantity,
wherein the sensor circuit comprises at least one sensing composition comprising
a variable resistor having a resistance depending on the physical quantity;
a first amplifier arrangement for outputting an output signal based on the resistance of the variable resistor, wherein the first amplifier arrangement comprises one field-effect transistor or a plurality of field-effect transistors in a telescopic cascode configuration or a plurality of field-effect transistors in a folded cascode configuration, wherein the first amplifier arrangement comprises an outer source terminal and an outer drain terminal, wherein a first terminal of the variable resistor is connected to the outer source terminal, such that the field-effect transistor having the outer source terminal and the variable resistor form a series circuit;
a feedback arrangement for feedbacking at least a part of the output signal of the first amplifier arrangement, which is obtained at the outer drain terminal, to at least one gate terminal of the field-effect transistors of the amplifier arrangement, wherein the feedback arrangement comprises at least one passive or active electronic component, which connects the outer drain terminal to the gate terminal of the field-effect transistor having the outer source terminal; and
a first current source for biasing the series circuit of the field-effect transistor having the outer source terminal and the variable resistor.

The resistance of the variable resistor may depend on any physical quantity. For example, the physical quantity may be a temperature, a force, a pressure or an energy of an electromagnetic field.

The first amplifier arrangement may comprise one field-effect transistor or a plurality of field-effect transistors in a telescopic cascode configuration or in a folded cascode configuration.

In the a first case with a plurality of field-effect transistors the field-effect transistors are arranged in such way that a drain terminal of a first transistor is connected to a source terminal of a second transistor, a drain terminal of the second transistor is connected to a source terminal of a third transistor (if any) and so on. The field-effect transistors are herein of the same type. E.g. all of the field-effect transistors are n-type field-effect transistors or all of the field-effect transistors are p-type field-effect transistors. Such configuration is also referred to as telescopic cascode configuration.

In a second case with a plurality of field-effect transistors the field-effect transistors are arranged in such way that a drain terminal of a first transistor is connected to a source terminal of a second transistor, a drain terminal of the second transistor is connected to a source terminal of a third transistor (if any) and so on. The first field-effect transistor and the further field-effect transistors are herein of the opposite type. That means that if the first field-effect transistor is n-type field-effect transistor all of the further field-effect transistors are p-type field-effect transistors and vice versa. Such configuration is also referred to as folded cascode configuration.

The first amplifier arrangement comprises an outer source terminal and an outer drain terminal, wherein, in case that only one transistor is used, the term outer source terminal refers to the source terminal of the transistor and there in the term outer drain terminal refers to the drain of the transistor. In case that a telescopic or folded cascode of transistors is used, the term outer source terminal refers to the source terminal, which is not connected to the drain of another transistor of the cascode. In a similar way, the term outer drain terminal refers to the drain terminal, which is not connected to the source terminal of another transistor of the cascode. In the examples above, the outer source terminal is the source terminal of the first transistor and outer drain terminal is the drain terminal the third transistor.

An electronic component is any basic discrete or integrated device used to affect electrons or their associated fields. Electronic components and electrical lines connecting the electronic components form an electrical circuit. For the feedback arrangement passive or active electronic components, in particular resistors, capacitors, inductors, transistors and/or diodes, may be used in order to feedback at least a part of the output signal of the first amplifier arrangement to one of the gate terminals of the field effect transistors.

The invention provides current re-use of the biasing current of the amplifiers input stage for biasing the sensor. For on-chip analog signal processing where high current drive capability is not needed usually one-stage amplifiers are enough to offer high open loop gain. In case of such an amplifier the current consumption of the sensor-electronic system can be reduced to the current consumption of the sensor.

According to the invention the biasing circuit is the amplification circuit. Therefore, all noise sources internal to the amplifier excluding the input pair are divided by the transconductance (gm) of the input stage, which is the ratio of the current change at the output port to the voltage change at the input port. Additionally the biasing is a current bias providing a highly linear readout.

Further, the invention provides a reduction in area due to the use of one circuit for biasing and amplification.

Moreover, the invention provides direct high impendent input for resistive sensors. Sensor impedance independent closed loop gain definition offers high precision and process variation immunity (assuming a high open loop gain) without adding additional power consumption.

The invention may be used for inertial sensors, biomedical sensors, gyroscopes, accelerometers, magnetometers, temperature sensors, pressure sensors, strain gauges, vibrational sensors, acoustic sensors and other sensor.

As a summary, the proposed sensor circuit can be used for resistive sensors and provides a well-defined closed loop signal gain with high performance (low noise, high linearity) and low power consumption. For the minimal use-case only the biasing current of the sensor is used without adding additional power consumption to the sensor circuit. The sensor bias-point is independent of supply voltage variations.

In addition the proposed system is compatible with single ended or differential operations, low frequency noise cancellation techniques (chopping) instrumentation amplifier configurations and with ratiometric measurements. In preferred embodiments of the invention the current source is arranged between the first amplifier arrangement and a first voltage supply. In this case the output signal is independent of the voltage of the first voltage supply.

In preferred embodiments of the invention the sensing composition comprises at least one second amplifier arrangement configured to amplify the output signal of the first amplifier arrangement or a signal derived from the output signal in order to obtain an amplified output signal. By this, the bias current may be stabilized as the bias current gets independent from the load to which the measurement signal of the sensor circuit is fed to. Furthermore, a higher gain may be achieved. By using a second amplifier arrangement the measurement signal may directly be fed to load impedances having a resistance or in other words a real part.

In some embodiments of the invention the second amplifier arrangement is designed as a non-inverting amplifier arrangement. This feature ensures that all components of the measurement signal have the same phase of the output signal of the first amplifier arrangement.

In preferred embodiments of the invention the sensor circuit comprises a first sensing composition and a second sensing composition, which are arranged in a differential configuration. In this case the output signal of the first sensing composition and the output signal of a second sensing composition define a bipolar output voltage. This means that the differential output voltage may be positive or negative.

In some embodiments a third current source is configured to create a virtual ground for the first sensing composition and the second sensing composition. By this fully differential sensor circuit may be obtained.

In preferred embodiments of the invention the second amplifier arrangement is designed as an inverting amplifier arrangement. In combination with virtual ground for the first sensing composition and the second sensing composition this allows separating common mode feedback from differential mode feedback. However, for this configuration additional common mode control is necessary.

In some embodiments the variable resistor is configured to generate a modulated input voltage for the first amplifier arrangement and the output signal of the first amplifier arrangement is fed to a mixer for downmixing the output signal to direct current. The variable resistor may be configured to detect the movement of a vibrating part of the gyroscope. The modulation may be in particular an amplitude modulation (AM).

In preferred embodiments of the invention the feedback arrangement of the first amplifier arrangement has a high pass transfer function. By this feature direct current voltages at the input can be rejected.

In some embodiments of the invention an output signal of the mixer is fed to a third amplifier arrangement, wherein a feedback arrangement for the third amplifier arrangement has a low pass transfer function. By this feature unwanted signal parts having a high-frequency may be filtered out in an easy way.

In some embodiments the third amplifier arrangement is designed as a fully differential amplifier. A fully differential amplifier, usually referred to as an 'FDA' for brevity, is a DC-coupled high-gain electronic voltage amplifier with differential inputs and differential outputs. The output signal of the fully differential amplifier is controlled by two feedback arrangements which, because of the amplifier's high gain, almost completely determines the output voltage signal for any given input.

Preferred embodiments of the invention are subsequently discussed with respect to the accompanying drawings, in which:

Fig. 1a     illustrates an embodiment of a sensor circuit having a single-ended configuration;

Fig. 1b     shows an abstract view of the embodiment of figure 1 a;

Fig. 2a     illustrates an abstract view of an embodiment of a sensor circuit having a differential configuration;

Fig. 2b     illustrates an embodiment of a sensor circuit having a simple single-stage pseudo differential configuration;

Fig. 2c     illustrates an embodiment of a sensor circuit having a single-stage pseudo differential telescopic cascode configuration;

Fig. 2d     illustrates an embodiment of a sensor circuit having a single-stage pseudo differential folded cascode configuration;

Fig. 2e     shows an abstract view of a sensor circuit having a two-stage pseudo differential configuration;

Fig. 2f     illustrates an embodiment of a sensor circuit having a two-stage fully differential configuration; and

Fig. 3     illustrates an embodiment of a sensor circuit having a front-end configuration for amplitude modulated sensor signals.

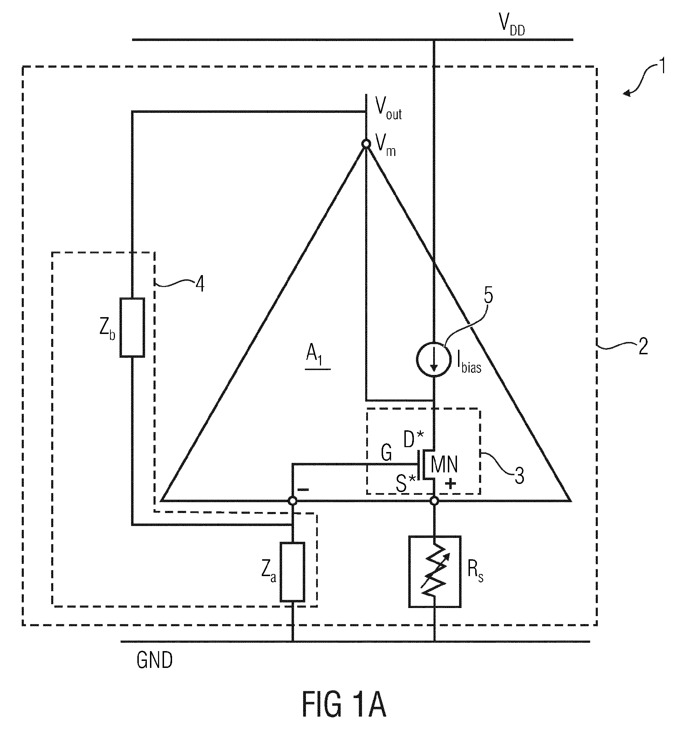

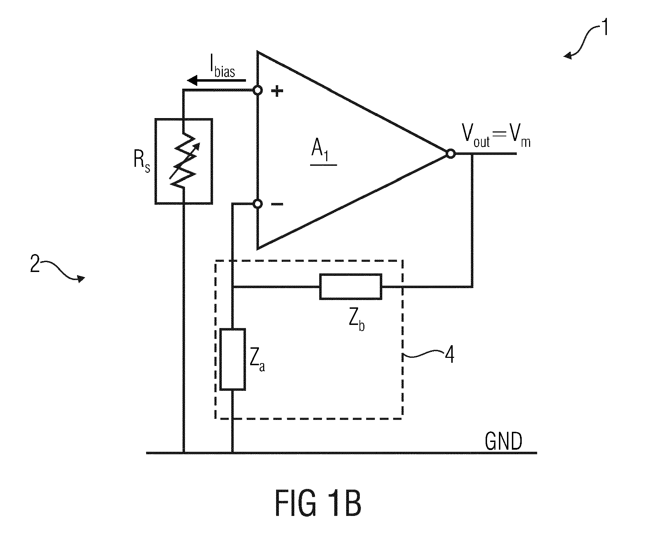

Figure 1a illustrates an embodiment of a sensor circuit 1 having a single-ended configuration and Fig. 1 b shows an abstract view of the embodiment of figure 1a.

The sensor circuit 1 for measuring a physical quantity, comprises one sensing composition 2 comprising:

a variable resistor $R_S$ having a resistance depending on the physical quantity;

a first amplifier arrangement 3 for outputting an output signal $V_{out}$ based on the resistance of the variable resistor $R_S$, wherein the first amplifier arrangement 3 comprises one field-effect transistor MN, wherein the first amplifier arrangement 3 comprises an outer source terminal S* and an outer drain terminal D*, wherein a first terminal of the variable resistor $R_S$, is connected to the outer source terminal S of the amplifier arrangement 3, such that the field-effect transistor MN having the outer source terminal S* and the variable resistor $R_S$ form a series circuit;

a feedback arrangement 4 for feedbacking at least a part of the output signal $V_{out}$ of the first amplifier arrangement 3, which is obtained at the outer drain terminal D* of the amplifier arrangement 3; $3_p$, $3_n$, to at least one gate terminal G of the field-effect transistor MN of the amplifier arrangement 3, wherein the feedback arrangement 4 comprises at least one electronic component $Z_b$, which connects the outer drain terminal D* of the amplifier arrangement 3 to the gate terminal G of the field-effect transistor MN having the outer source terminal; and

a first current source 5 for biasing the series circuit of the of the field-effect transistor MN having the outer source terminal and the variable resistor $R_s$.

The resistance of the variable resistor $R_S$ may depend on any physical quantity. For example, the physical quantity may be a temperature, a force, a pressure or an energy of an electromagnetic field.

An electronic component is any basic discrete or integrated device used to affect electrons or their associated fields. Electronic components and electrical lines connecting the electronic components form an electrical circuit. For the feedback arrangement passive or active electronic components, in particular resistors, capacitors, inductors, transistors and/or diodes, may be used in order to feedback at least a part of the output signal of the first amplifier arrangement to one of the gate terminals of the field effect transistors.

The feedback arrangement 4 in figure s 1a and 1b consists of an impedance $Z_b$, which is directly connected to the outer drain terminal D*and the gate G of the field effect transistor MN, and an impedance $Z_a$, which is connected to the second voltage supply GND and the gate G of the field effect transistor MN. The impedances $Z_a$ and $Z_b$ form a voltage divider, so that a part of the output signal $V_{out}$ is fed back to the gate G of the field effect transistor MN. The second voltage supply GND may be on ground level or any other voltage level. In figure 1 the output signal $V_{out}$ may directly be used as a measuring signal $V_m$.

In figure 1 a it is assumed that the load to which the measuring signal $V_m$ is fed is at dc much larger than the output impedance of the amplifier. Furthermore, it is assumed that the feedback arrangement 4 is as well in dc much larger than the output impedance of the amplifier. In this case the current $I_{bias}$ provided by the current source 5 is completely used to bias the first amplifier arrangement 3 and the variable resistance $R_s$.

In the embodiment of figure 1a the current source 5 and the first amplifier arrangement 3 are arranged in an integrated circuit A1. However, other arrangements are possible.

The figures 1 a and 1 b show the main idea of the invention in a single ended matter. The resistor Rs is amplified and biased by the amplifier 3. Shown in Figure 1a is the internal asymmetric input structure of the proposed invention. The positive input is high impendent with a DC current different than zero, whereas the negative input is high impendent with a DC current around zero. The closed loop gain is defined solely by the feedback network consisting of Z_a and Z_b which are well matched on-chip devices. The amplifier and the sensor share the same biasing current.

Figure 1 b shows the external non-inverting configuration of the amplifier. The biasing of the resistor Rs is established through the DC current $I_{bia}$, flowing out of the positive input of the amplifier 3.

The resistive sensor Rs can be described the by the equation

$$R_s \,=\, R_0 \pm \Delta R_s \,(1)$$

The resistive change $\Delta R_s$ is dependent of the sensed physical quantity. For a differential operation two sensors are needed with variable change of opposite sign.

When biased with a DC current equation (1) can be rewritten as

$$I_{bias} \cdot R_s \,=\, V_s \,=\, I_{bias} \cdot R_0 \,+\, I_{bias} \cdot \Delta R_s \,=\, V_0 \,+\, \Delta V_s \,(2)$$

The invention provides current re-use of the biasing current $I_{bias}$ of the amplifiers input stage 3 for biasing the sensor $R_s$. For on-chip analog signal processing where high current drive capability is not needed usually one-stage amplifiers are enough to offer high open loop gain. In case of such an amplifier 3 the current consumption of the sensor circuit 1 can be reduced to the current consumption of the sensor $R_s$.

According to the invention the biasing circuit is the amplification circuit 3. Therefore, all noise sources internal to the amplifier 3 excluding the input pair are divided by the transconductance (gm) of the input stage 3, which is the ratio of the current change at the output port to the voltage change at the input port. Additionally the biasing is a current bias providing a highly linear readout.

Further, the invention provides a reduction in area due to the use of one circuit 3 for biasing and amplification.

Moreover, the invention provides direct high impendent input for resistive sensors $R_s$. Sensor impedance independent closed loop gain definition offers high precision and process variation immunity (assuming a high open loop gain) without adding additional power consumption.

The invention may be used for inertial sensors, biomedical sensors, gyroscopes, accelerometers, magnetometers, temperature sensors, pressure sensors, strain gauges, vibrational sensors, acoustic sensors and other sensor.

As a summary, the proposed sensor circuit can be used for resistive sensors $R_s$ and provides a well-defined closed loop signal gain with high performance (low noise, high linearity) and low power consumption. For the minimal use-case only the biasing current of the sensor $R_s$ is used without adding additional power consumption to the sensor circuit 1. The sensor bias-point is independent of supply voltage variations.

In addition the proposed system 1 is compatible with single ended or differential operations, low frequency noise cancelation techniques (chopping) instrumentation amplifier configurations and with ratiometric measurements.

In preferred embodiments of the invention the current source 5 is arranged between the outer drain terminal D* of the first amplifier arrangement 3 and a first voltage supply $V_{DD}$. In this case the output signal $V_{out}$ is independent of the voltage of the first voltage supply $V_{DD}$.

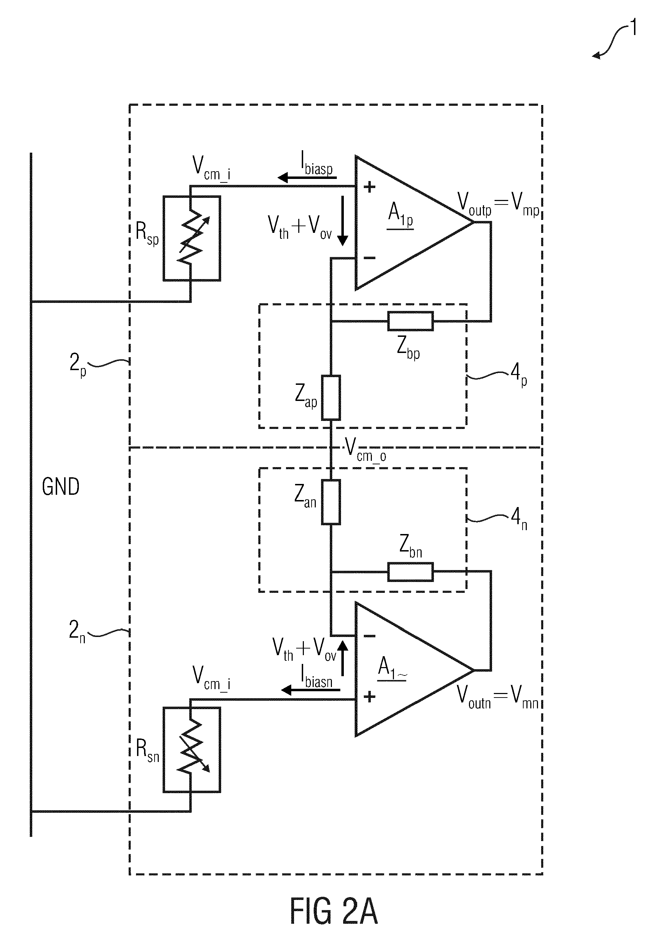

Figure 2a illustrates an abstract view of an embodiment of a sensor circuit 1 having a differential configuration. In the embodiment of figure 1 the sensor circuit 1 comprises a first sensing composition $2_p$ and a second sensing composition $2_n$, which are arranged in a differential configuration. In this case the output signal $V_{outp}$, which is the measuring signal $V_{mp}$ of the first sensing composition $2_p$, and the output signal $V_{mn}$, which is the measuring signal $V_{mp}$ of the second sensing composition $2_n$ define a bipolar output voltage $V_{mp}$-$V_{mn}$. This means that the differential output voltage $V_{mp}$-$V_{mn}$ may be positive or negative.

The integrated circuits $A_{1p}$ and $A_{1n}$ are designed similarly to the integrated circuit $A_1$ of figure 1 a.

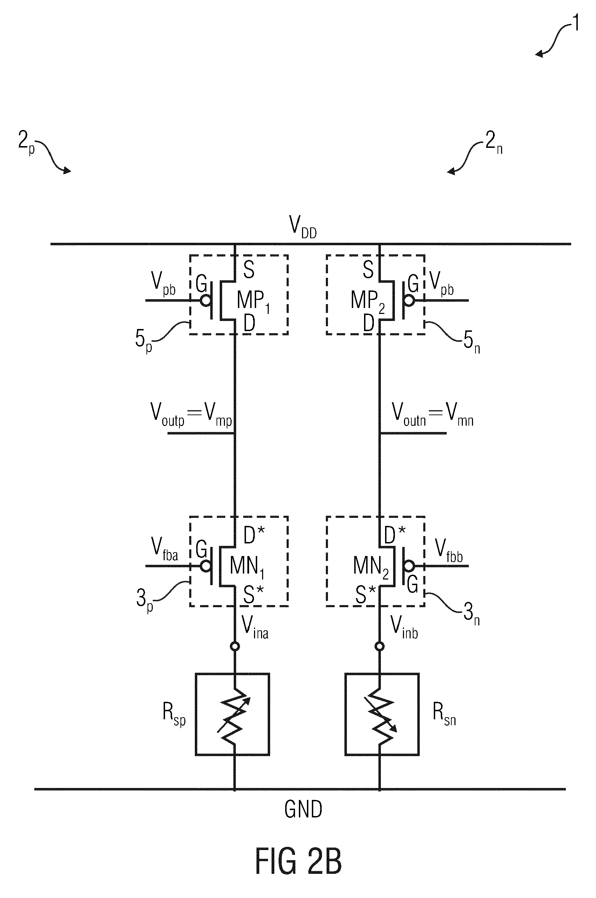

Figures 2b-2f show different implementations with the structure of the differential non-inverting one stage amplifier shown in 2a. External impedances are not shown for simplicity.

Differential non-inverting amplifier have the property of copying the common mode voltage $V_{cm\_i}$ of the input to the common mode voltage $V_{cm\_o}$ of the output ($V_{cm\_i} = V_{cm\_o}$, Figure2a), in the specific case of the asymmetric structure of the invention the common mode output voltage $V_{cm\_o}$ is the common mode input voltage $V_{cm\_i}$ plus the overdrive voltage $V_{ov}$ and the threshold voltage $V_{th}$ of the input transistor MN ($V_{cm-o} = V_{cm\_i} + V_{ov} + V_{th}$). This property of the amplifier $3_p$, $3_n$ restricts and allows the operation of the variable resistors $R_{Sn}$, $R_{Sp}$ close to the rail voltage GND, while the amplified signal $V_{outp}$, $V_{outn}$ is placed around the middle range of the supply $V_{DD}$-GND. Depending on the structure (2b-2f) and, if it is needed to change the common mode output voltage $V_{cm-o}$, two approaches are possible, a common mode feedback circuit to control the output common mode or a common mode level shifter (solution used in instrumentation amplifiers). Note that in this paragraph the indices p for the first sensing composition $2_p$ and n for the second sensing composition $2_n$ are omitted as the explanations given herein are valid for both sensing compositions $2_p$ and $2_n$.

Figure 2b illustrates an embodiment of a sensor circuit 1 having a simple single-stage pseudo differential configuration. Studying the simplest configuration in Figure 2b and assuming that all field-effect transistors $MN_1$, $MN_2$ are biased with a stable operating point in saturation region it can found that the resistors $R_{Sp}$ and $R_{Sn}$ are biased with the bias current $I_{biasp}$ or $I_{biasn}$ of the respective first amplifier arrangement $3_p$ or $3_n$, wherein the bias currents $I_{biasp}$ and $I_{biasn}$ are generated by the respective current source $5_p$ formed by field effect transistor $MP_1$ or current source $5_n$ formed by field effect transistor $MP_2$. The resulting voltage change across the sensors $R_{Sp\ and}\ R_{Sn}$ is $\Delta V_S = I_{bias} \cdot \Delta R_s$. The DC component of the sensors $R_{Sp\ and}\ R_{Sn}$ is $I_{bias} \cdot R_0$, which is the input common mode voltage, is rejected due to the differential configuration, assuming matching sensor resistors $R_{Sp}$ and $R_{Sn}$. Therefore for high enough open loop gain the transfer function of the amplifier can be written:

$$A_c = \frac{V_{out}}{V_s} \simeq 1 + \frac{Z_b}{Z_a} \ (3)$$

Figure 2b shows the most basic configuration of the invention, it can be used for one or higher stage amplifier. The input pair $MN_p$, $MN_n$ is the main noise contributor all other noise sources are divided by the transconductance $g_m$ of this pair. The field-effect transistors $MP_1$ and $MP_2$ provide the biasing currents $I_{biasp}$ and $I_{biasn}$.

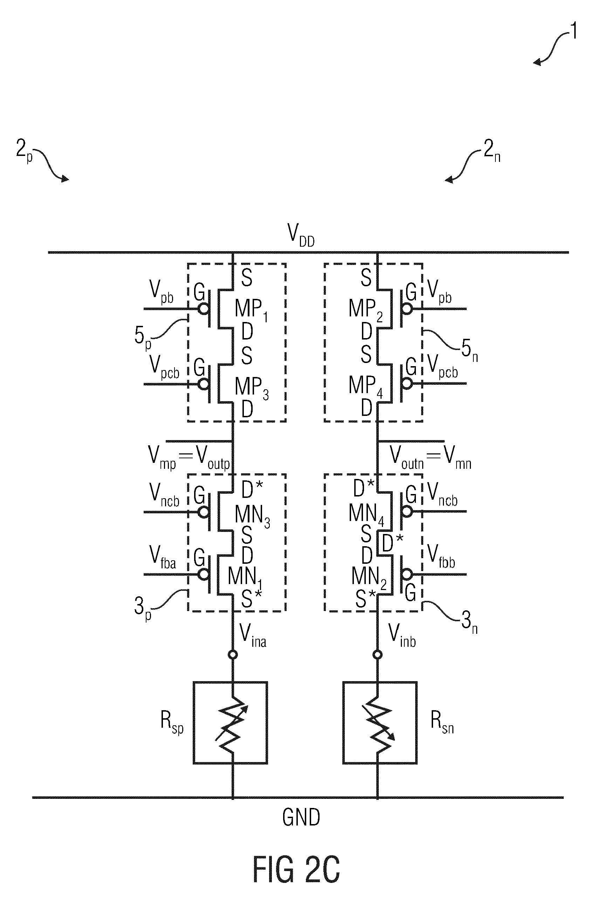

Figure 2c illustrates an embodiment of a sensor circuit having a single-stage pseudo differential telescopic cascode configuration. This structure may be used for two or higher stage amplifiers.

In the embodiment of figure 2c each of the sensing compositions $2_p$, $2_n$ comprise a variable resistor $R_{Sp}$, $R_{Sn}$ having a resistance depending on the physical quantity;

a first amplifier arrangement $3_p$, $3_n$ for outputting an output signal $V_{outp}$, $V_{outn}$ based on the resistance of the variable resistor $R_{Sp}$, $R_{Sn}$, wherein the first amplifier arrangement $3_p$, $3_n$ comprises a plurality of field-effect transistors $MN_1$, $MN_3$; $MN_2$, $MN_4$ in a telescopic cascode configuration, wherein the first amplifier arrangement $3_p$, $3_n$ comprises an outer source terminal S* and an outer drain terminal D*, wherein a first terminal of the variable resistor $R_{Sp}$, $R_{Sn}$, is connected to the outer source terminal S of the amplifier arrangement $3_p$, $3_n$, such that the field-effect transistor $MN_1$, $MN_3$; $MN_2$, $MN_4$ having the outer source S* and the variable resistor $R_Q$; $R_{Sp}$, $R_{Sn}$ form a series circuit;

a feedback arrangement $4_p$, $4_n$ for feedbacking at least a part of the output signal $V_{outp}$, $V_{outn}$ of the first amplifier arrangement $3_p$, $3_n$, which is obtained at the outer drain terminal D* of the amplifier arrangement $3_p$, $3_n$, to at least one gate terminal G of the field-effect transistors $MN_1$; $MN_2$ of the amplifier arrangement $3_p$, $3_n$, wherein the feedback arrangement $4_p$, $4_n$ comprises at least one passive or active electronic component $Z_{bp}$, $Z_{bn}$ (not shown in figure 2c), which connects the outer drain terminal D* of the amplifier arrangement $3_p$, $3_n$ to the gate terminal G of the field-effect transistor $MN_1$; $MN_2$ having the outer source S*; and

a first current source $5_p$, $5_n$ for biasing the series circuit of the field-effect transistor $MN_1$; $MN_2$ having the outer source S* and the variable resistor $R_{Sp}$, $R_{Sn}$.

Each of the first amplifier arrangements $3_p$, $3_n$ comprises a plurality of field-effect transistors $MN_1$, $MN_3$; $MN_2$, $MN_4$. The field-effect transistors $MN_1$, $MN_3$; $MN_2$, $MN_4$ are arranged in such way that a drain terminal D of a first transistor $MN_1$, MN3 is connected to a source terminal S of a second transistor $MN_2$, $MN_4$. The field-effect transistors $MN_1$, $MN_3$; $MN_2$, $MN_4$ are herein of the same type. E.g. all of the field-effect transistors $MN_1$, $MN_3$; $MN_2$, $MN_4$ are n-type field-effect transistors $MN_1$, $MN_3$; $MN_2$, $MN_4$. Such configuration is also referred to as telescopic cascode configuration.

Each of the first amplifier arrangement $3_p$, $3_n$ comprises an outer source terminal S* and an outer drain terminal D*, wherein the term outer source terminal refers to the source terminal S*, which is not connected to the drain D of the other transistor $MN_3$, $MN_4$ of the cascode. In a similar way, the term outer drain terminal refers to the drain terminal D*, which is not connected to the source terminal S of the other transistor $MN_1$, $MN_2$ of the cascode.

In contrast to the sensing circuit 1 of figure 2b each of the first current sources $5_p$, $5_n$ comprise a plurality of field effect transistors $MP_1$, $MP_3$; $MP_2$,MP4 in a telescopic cascode configuration.

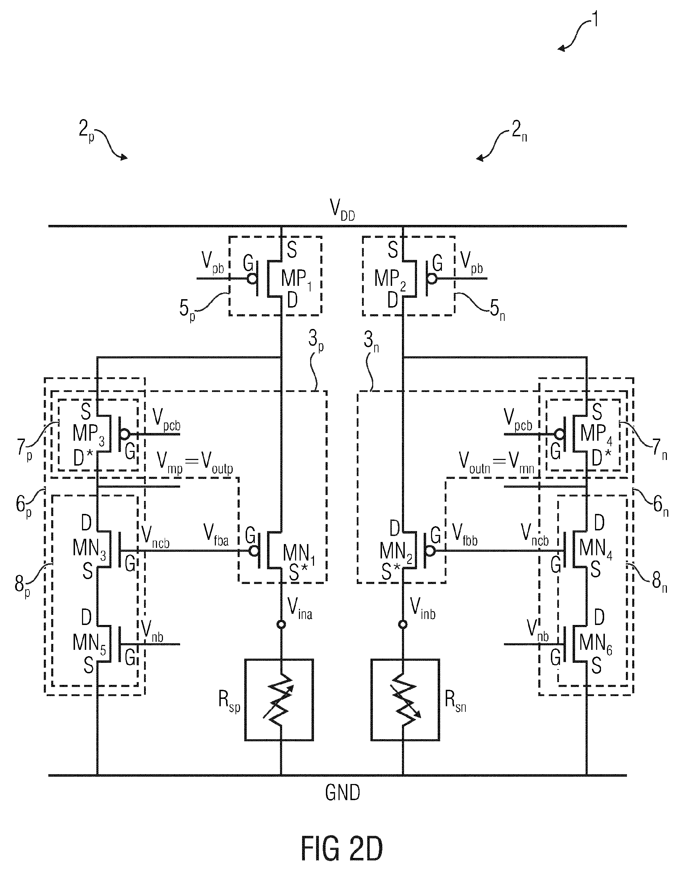

Figure 2d illustrates an embodiment of a sensor circuit having a single-stage pseudo differential folded cascode configuration.

In the embodiment of figure 2c each of the sensing compositions $2_p$, $2_n$ comprise

a variable resistor $R_{Sp}$, $R_{Sn}$ having a resistance depending on the physical quantity;

a first amplifier arrangement $3_p$, $3_n$ for outputting an output signal $V_{outp}$, $V_{outn}$ based on the resistance of the variable resistor $R_{Sp}$, $R_{Sn}$, wherein the first amplifier arrangement $3_p$, $3_n$ comprises a plurality of field-effect transistors $MN_1$, $MN_3$; $MN_2$, $MN_4$ in a folded cascode configuration, wherein the first amplifier arrangement 3p, $3_n$ comprises an outer source terminal S* and an outer drain terminal D*, wherein a first terminal of the variable resistor $R_{Sp}$, $R_{Sn}$, is connected to the outer source terminal S of the amplifier arrangement $3_p$, $3_n$, such that the field-effect transistor $MN_1$, $MN_3$; $MN_2$, $MN_4$ having the outer source S* and the variable resistor $R_S$; $R_{Sp}$, $R_{Sn}$ form a series circuit;

a feedback arrangement $4_p$, $4_n$ for feedbacking at least a part of the output signal $V_{outp}$, $V_{outn}$ of the first amplifier arrangement $3_p$, $3_n$, which is obtained at the outer drain terminal D* of the amplifier arrangement $3_p$, $3_n$, to at least one gate terminal G of the field-effect transistors $MN_1$; $MN_2$ of the amplifier arrangement $3_p$, $3_n$, wherein the feedback arrangement 4p, $4_n$ comprises at least one passive or active electronic component $Z_{bp}$, $Z_{bn}$ (not shown in figure 2c), which connects the outer drain terminal D* of the amplifier arrangement 3p, $3_n$ to the gate terminal G of the field-effect transistor $MN_1$; $MN_2$ having the outer source S*; and

a first current source $5_p$, $5_n$ for biasing the series circuit of the field-effect transistor $MN_1$; $MN_2$ having the outer source S* and the variable resistor $R_{Sp}$, $R_{Sn}$.

In a this embodiment with a plurality of field-effect transistors $MN_1$, $MN_3$; $MN_2$, $MN_4$ the field-effect transistors $MN_1$, $MP_3$; $MN_2$,MP4 are arranged in such way that a drain terminal D of a first transistor $MN_1$; $MN_2$ is connected to a source terminal S of a further transistor $MP_3$; $MP_4$, The first field-effect transistors $MN_1$; $MN_2$ and the further field-effect transistors $MP_3$; $MP_4$ are herein of the opposite type. That means that if the first field-effect transistor $MN_1$; $MN_2$ are n-type field-effect transistors $MN_1$; $MN_2$ and the further field-effect transistors $MP_3$; $MP_4$ are p-type field-effect transistors $MP_3$; $MP_4$. Such configuration is also referred to as folded cascode configuration.

It can be used for one or higher stage amplifiers. Higher gain can be achieved with a small additional output current. In the embodiment of figure 2d each of the sensing compositions $2_p$, $2_n$ comprises a second current path $6_p$, $6_n$ arranged parallel to the series circuit $3_p$, $3_n$; $R_{Sp}$, $R_{Sn}$ of the amplifier arrangement $3_p$, $3_n$ and the variable resistor $R_{Sp}$, $R_{Sn}$, wherein the second current paths $6_p$, $6_n$ comprise a cascode element $7_p$, $7_n$ comprising the transistors $MP_3$; $MP_4$ and a second current source $8_p$, $8_n$, wherein field-effect transistors $MN_1$; $MN_2$ and the field-effect transistors $MP_3$; $MP_4$ form a folded cascode. In this case the output signals $V_{outp}$, $V_{outn}$ of the first amplifier stages Sp and 3n forming the measuring signals $V_{mp}$ and $V_{mn}$ may be obtained between the cascode elements $7_p$, $7_n$ and the second current sources $8_p$, $8_n$. Hereby, output impedance may be increased.

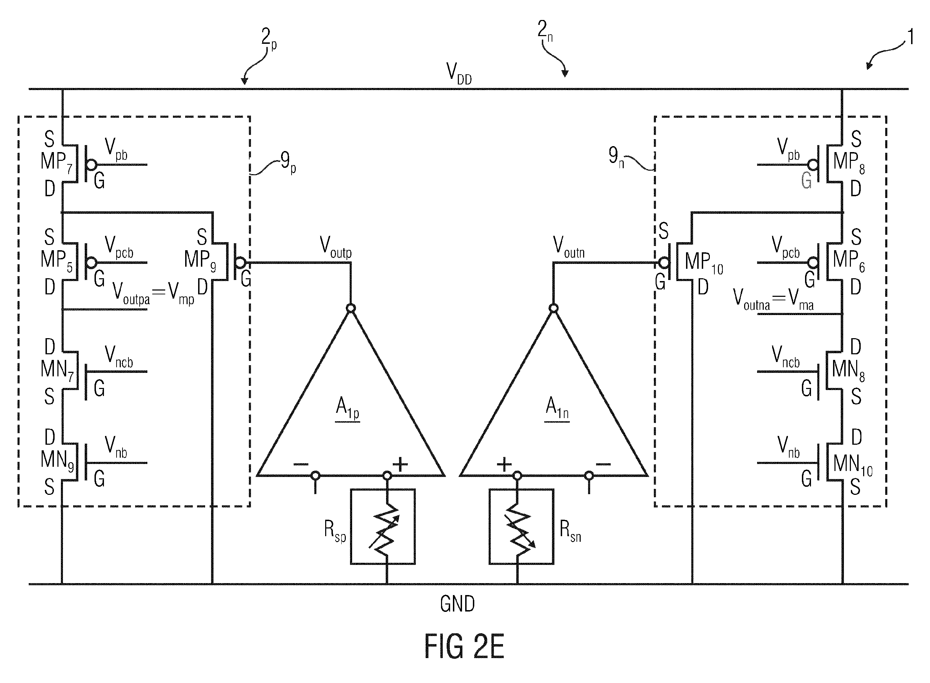

Figure 2e shows an abstract view of a sensor circuit 1 having a two-stage pseudo differential configuration. It can be used with one of the above first stages. In the embodiment of figure 2e each of the sensing compositions $2_p$, $2_n$

comprises at least one second amplifier arrangement $9_p$, $9_n$ configured to amplify the output signal $V_{outp}$, $V_{outn}$ of the first amplifier arrangement $3_p$, $3_n$ or a signal derived from the output signal $V_{outp}$, $V_{outn}$ in order to obtain an amplified output signal $V_{outpa}$, $V_{outna}$. By this, the bias currents $I_{biasp}$, $I_{biasn}$ may be stabilized as the bias currents $I_{biasp}$, $I_{biasn}$ get independent from the load to which the measurement signal $V_{mp}$, $V_{mn}$ of the sensor circuit 1 is fed to. Furthermore, a higher gain may be achieved. By using a second amplifier arrangement $9_p$, $9_n$ the measurement signal $V_{mp}$, $V_{mn}$ may directly be fed to load impedances having a resistance lower than the output resistance of the second amplifier arrangement.

Each of the second amplifier arrangements $9_p$, $9_n$ comprises an input field-effect transistor $MP_9$, $MP_{10}$ to which the respective output signal $V_{outp}$, $V_{outn}$ of the first amplifier arrangement $3_p$, $3_n$ is fed. Furthermore, each of the second amplifier arrangements $9_p$, $9_n$ comprises an field-effect transistor output arrangement $MP_7$, $MP_5$, $MN_7$, $NP_9$; $MP_7$, $MP_5$, $MN_7$, $NP_9$, which is configured as a non-inverting output stage. This feature ensures that all components of the measurement signal $V_{mp}$, $V_{mn}$ have the same phase of the output signal $V_{outp}$, $V_{outn}$ of the first amplifier arrangement $3_p$, $3_n$.

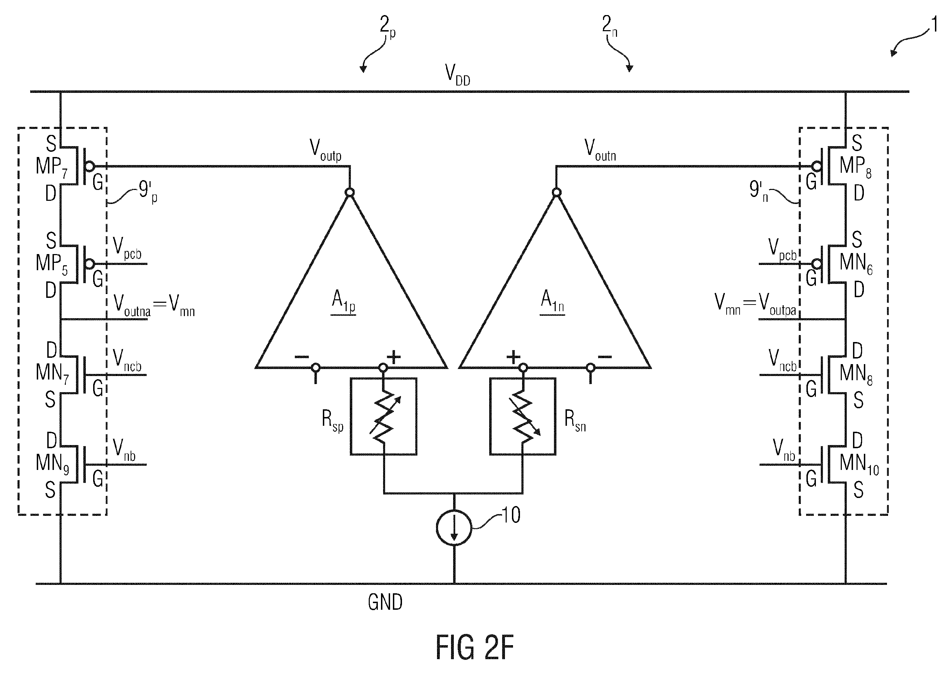

Figure 2f illustrates an embodiment of a sensor circuit 1 having a two-stage fully differential configuration having second amplifier arrangements $9_p$, $9_n$ with inverting output stages $MP_7$, $MP_5$, $MN_7$, $NP_9$; $MP_7$, $MP_5$, $MN_7$, $NP_9$. This allows separating common mode feedback from differential mode feedback. For this configuration additional common mode control is necessary. A third current source 10 is placed to create a virtual ground. By this fully differential sensor circuit may be obtained. This allows separating common mode feedback from differential mode feedback. For this configuration additional common mode control is necessary. The shown current source 10 can be added in each of the circuits from 2b-2f as long as the sensor topology allows it.

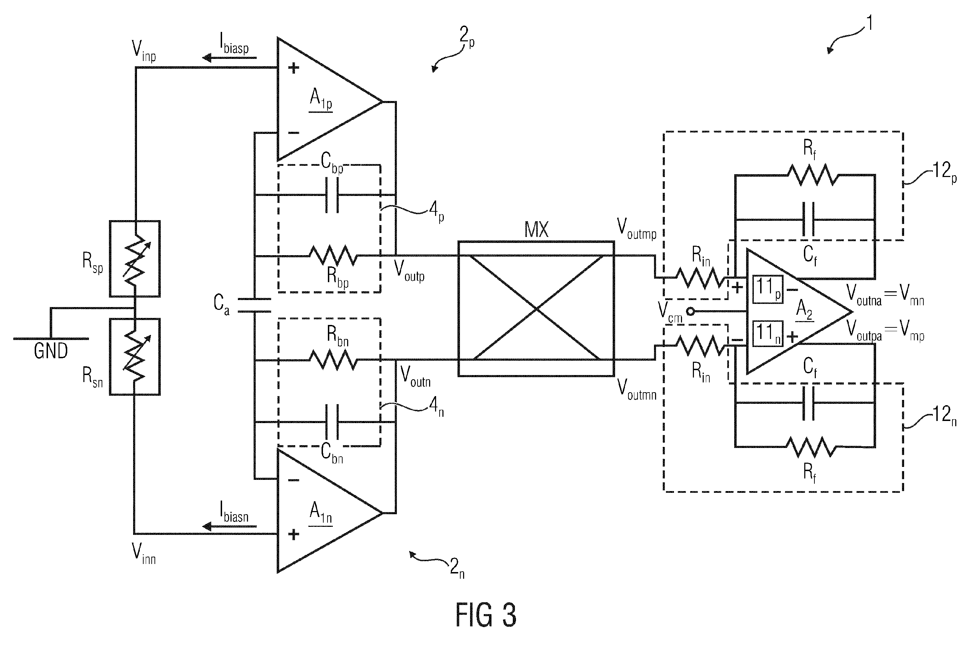

Figure 3 illustrates an embodiment of a sensor circuit 1 having a front-end configuration for amplitude modulated sensor signals. In the embodiment of figure 3 the variable resistor $R_{Sp}$, $R_{Sn}$ of each sensing composition $2_p$, $2_n$ is configured to generate a modulated input voltage $V_{inp}$, $V_{inn}$ for the respective first amplifier arrangement $3_p$, $3_n$ and the output signal $V_{outp}$, $V_{outn}$ of the first amplifier arrangement $3_p$, $3_n$ is fed to a mixer MX for downmixing the output signal $V_{outp}$, $V_{outn}$ to direct current. The variable resistor $R_{Sp}$, $R_{Sn}$ may be configured to detect the movement of a vibrating part of the gyroscope. The modulation may be in particular an amplitude modulation (AM).

In preferred embodiments of the invention the feedback arrangement $4_p$, $4_n$ of the first amplifier arrangement $3_p$, $3_n$ has a high pass transfer function. By this feature direct current voltages at the input can be rejected.

In some embodiments of the invention an output signal $V_{outmp}$, $V_{outmn}$ of the mixer MX is fed to a third amplifier arrangement $11_p$, $11_n$, wherein a feedback arrangement $12_p$, $12_n$ for the third amplifier arrangement $11_p$, $11_n$ has a low pass transfer function. By this feature unwanted signal parts having a high-frequency may be filtered out from the output signal $V_{outmp}$, $V_{outmn}$ of the mixer MX in an easy way.

In some embodiments the third amplifier arrangement $11_p$, $11_n$ is designed as a fully differential amplifier $11_p$, $11_n$. A fully differential amplifier $11_p$, $11_n$, usually referred to as an 'FDA' for brevity, is a DC-coupled high-gain electronic voltage amplifier $11_p$, $11_n$ with differential inputs and differential outputs. The output signal $V_{outmp}$, $V_{outmn}$ of the fully differential amplifier $11_p$, $11_n$ is controlled by the two feedback arrangements $12_p$, $12_n$ which, because of the amplifier's high gain, almost completely determines the output voltage signal $V_{outmp}$, $V_{outmn}$ for any given input.

In figure 3 a possible front-end implementation for a sensors $R_{Sp}$, $R_{Sn}$ generating a modulated AM input signal, such as vibrating gyroscopes, is shown. Alternatively the same circuit can be used for signals to DC if a mixer is used at the positive input nodes, $V_{inp}$ and $V_{inn}$. The impedances noted previously as $Z_{an}$ and $Z_{ap}$ (figure 2a) are realized with a capacitor ($Z_{an} = Z_{ap} = 2 \cdot C_a$) whereas the impedances noted previously as $Z_{bp}$ and $Z_{bn}$ (figure 2a) are realized with a capacitor resistor configuration ($Z_{bn} = Z_{bp} = R_{bp} \parallel C_{bp} = R_{bn} \parallel C_{bn}$), which is resulting in a transfer function of a high pass filter. After the first stage the signal is mixed down to DC with MX and filtered through a low pass filter (second stage), in addition the second stage may be used to level shift the common mode output of the first stage to a preferred common mode voltage at the output of the second stage.

The research leading to these results has received funding from the European Union.

Reference signs:

1 sensor circuit
2 sensing composition
3 first amplifier arrangement
4 feedback arrangement
5 first current source
6 second current path
7 cascode element
8 second current source

| 9 | second amplifier arrangement |
|---|---|
| 10 | third current source |
| 11 | third amplifier arrangement |
| 12 | feedback arrangement |

| $R_S$ | variable resistor |
|---|---|
| $V_{out}$ | output signal |
| MN | field-effect transistor |
| S* | outer source terminal |
| D* | outer drain terminal |
| G | gate terminal |
| Z | impedance |
| $V_m$ | measuring signal |
| $V_{ov}$ | overdrive voltage |
| $V_{th}$ | threshold voltage |
| A | integrated circuit |
| $V_{DD}$ | first voltage supply |
| GND | second voltage supply |
| $I_{bias}$ | biasing current |
| S | source terminal |
| D | drain terminal |
| $V_{outa}$ | amplified output signal |
| C | capacitor |
| R | resistor |

**Claims**

1. A sensor circuit for measuring a physical quantity,
   wherein the sensor circuit (1) comprises at least one sensing composition (2; $2_p$, $2_n$) comprising:

   a variable resistor ($R_S$; $R_{Sp}$, $R_{Sn}$) having a resistance depending on the physical quantity;
   a first amplifier arrangement (3; $3_p$, $3_n$) for outputting an output signal ($V_{out}$; $V_{outp}$, $V_{outn}$) based on the resistance of the variable resistor ($R_S$; $R_{Sp}$, $R_{Sn}$), wherein the first amplifier arrangement (3; $3_p$, $3_n$) comprises one field-effect transistor (MN) or a plurality of field-effect transistors ($MN_1$, $MN_3$; $MN_2$,$MN_4$) in a telescopic cascode configuration or a plurality of field-effect transistors ($MN_1$, $MP_3$; $MN_2$,$MP_4$) in a folded cascode configuration, wherein the first amplifier arrangement (3; $3_p$, $3_n$) comprises an outer source terminal (S*) and an outer drain terminal (D*), wherein a first terminal of the variable resistor ($R_S$; $R_{Sp}$, $R_{Sn}$), is connected to the outer source terminal (S*) of the first amplifier arrangement (3; $3_p$, $3_n$), such that the field-effect transistor (MN; $MN_1$; $MN_2$) having the outer source terminal (S*) and the variable resistor ($R_S$; $R_{Sp}$, $R_{Sn}$) form a series circuit;
   a feedback arrangement (4; $4_p$, $4_n$) for feedbacking at least a part of the output signal ($V_{out}$; $V_{outp}$, $V_{outn}$) of the first amplifier arrangement (3; $3_p$, $3_n$), which is obtained at the outer drain terminal (D*) of the amplifier arrangement (3; $3_p$, $3_n$), to at least one gate terminal (G) of the field-effect transistors (MN; $MN_1$, $MN_3$; $MN_2$,$MN_4$) of the amplifier arrangement (3; $3_p$, $3_n$), wherein the feedback arrangement (4; $4_p$, $4_n$) comprises at least one passive or active electronic component ($Z_b$; $Z_{bp}$, $Z_{bn}$; $R_{bp}$, $C_{bp}$, $R_{bn}$, $C_{bn}$), which connects the outer drain terminal (D*) of the amplifier arrangement (3; $3_p$, $3_n$) to the gate terminal (G) of the field-effect transistor (MN; $MN_1$, ($MN_3$); $MN_2$,($MN_4$)) having the outer source terminal (S*); and
   a first current source (5; $5_p$, $5_n$) for biasing the series circuit of the field-effect transistor (MN; $MN_1$, $MN_3$; $MN_2$,$MN_4$) having the outer source terminal (S*) and the variable resistor ($R_S$; $R_{Sp}$, $R_{Sn}$).

2. A sensor circuit according to the foregoing claim, wherein the first current source (5; $5_p$, $5_n$) is arranged between first amplifier arrangement (3; $3_p$, $3_n$) and a first voltage supply ($V_{DD}$).

3. A sensor circuit according to one of the foregoing claims, wherein the sensing composition (2; $2_p$, $2_n$) comprises at least one second amplifier arrangement ($9_n$, $9_p$; $9'_n$, $9'_p$) configured to amplify the output signal ($V_{out}$; $V_{outp}$, $V_{outn}$) of the first amplifier arrangement (3; $3_p$, $3_n$) or a signal derived from the output signal ($V_{out}$; $V_{outp}$, $V_{outn}$) in order to obtain an amplified output signal ($V_{outpa}$, $V_{outna}$).

4. A sensor circuit according to the foregoing claim, wherein the second amplifier arrangement ($9_n$, $9_p$; $9'_n$, $9'_p$) is designed as a non-inverting amplifier arrangement ($9_n$, $9_p$).

5. A sensor circuit according to claim 3, wherein the second amplifier arrangement ($9_n$, $9_p$; $9'_n$, $9'p$) is designed as an inverting amplifier arrangement ($9'_n$, $9'_p$).

6. A sensor circuit according to one of the foregoing claims, wherein the sensor circuit (1) comprises a first sensing composition($2_p$) and a second sensing composition($2_n$), which are arranged in a differential configuration.

7. A sensor circuit according to the foregoing claim, wherein a third current source (10) is configured to create a virtual ground for the first sensing composition ($2_p$) and the second sensing composition ($2_n$).

8. A sensor circuit according to one of the foregoing claims, wherein the variable resistor ($R_S$; $R_{Sp}$, $R_{Sn}$) is configured to generate a modulated input voltage ($V_{inp}$, $V_{inn}$) for the first amplifier arrangement (3; $3_p$, $3_n$) and wherein the output signal ($V_{outp}$, $V_{outn}$) of the first amplifier arrangement (3; $3_p$, $3_n$) is fed to a mixer (MX) for downmixing the output signal ($V_{outp}$, $V_{outn}$) to direct current.

9. A sensor circuit according to one of the foregoing claims, wherein the feedback arrangement (4; $4_p$, $4_n$) of the first amplifier arrangement (3; $3_p$, $3_n$) is designed in such way that the first amplifier arrangement (3; $3_p$, $3_n$) has a high pass transfer function.

10. A sensor circuit according to the foregoing claim, wherein an output signal ($V_{outmp}$, $V_{outmn}$) of the mixer (MX) is fed to a third amplifier arrangement ($11_p$, $11_n$), wherein a feedback arrangement ($12_p$, $12_n$) for the third amplifier arrangement ($11_p$, $11_n$) is designed in such way that the third amplifier arrangement ($11_p$, $11_n$) has a low pass transfer function.

11. A sensor circuit according to the foregoing claim, wherein the third amplifier arrangement ($11_p$, $11_n$) is designed as a fully differential amplifier ($11_p$, $11_n$).

**Patentansprüche**

1. Eine Sensorschaltung zum Messen einer physikalischen Größe,
   wobei die Sensorschaltung (1) zumindest eine Erfassungszusammensetzung (2; $2_p$, $2_n$) aufweist, die folgende Merkmale aufweist:

   einen variablen Widerstand ($R_S$; $R_{Sp}$, $R_{Sn}$), der einen von der physikalischen Größe abhängigen Widerstandswert aufweist;
   eine erste Verstärkeranordnung (3; $3_p$, $3_n$) zum Ausgeben eines Ausgangssignals ($V_{out}$; $V_{outp}$, $V_{outn}$) basierend auf dem Widerstandswert des variablen Widerstandes ($R_S$; $R_{Sp}$, $R_{Sn}$), wobei die erste Verstärkeranordnung (3; $3_p$, $3_n$) einen Feldeffekttransistor (MN) oder eine Mehrzahl von Feldeffekttransistoren ($MN_1$, $MN_3$; $MN_2$, $MN_4$) in einer Teleskopische-Kaskade-Konfiguration oder eine Mehrzahl von Feldeffekttransistoren ($MN_1$ $MP_3$; $MN_2$, $MP_4$) in einer Gefaltete-Kaskade-Konfiguration aufweist, wobei die erste Verstärkeranordnung (3; $3_p$, $3_n$) einen äußeren Source-Anschluss (S*) und einen äußeren Drain-Anschluss (D*) aufweist, wobei ein erster Anschluss des variablen Widerstandes ($R_S$; $R_{Sp}$, $R_{Sn}$) mit dem äußeren Source-Anschluss (S*) der ersten Verstärkeranordnung (3; $3_p$, $3_n$) so verbunden ist, dass der Feldeffekttransistor (MN; $MN_1$; $MN_2$), der den äußeren Source-Anschluss (S*) aufweist, und der variable Widerstand ($R_S$; $R_{Sp}$, $R_{Sn}$) eine Reihenschaltung bilden;
   eine Rückkopplungsanordnung (4; $4_p$, $4_n$) zum Rückkoppeln zumindest eines Teiles des Ausgangssignals ($V_{out}$; $V_{outp}$, $V_{outn}$) der ersten Verstärkeranordnung (3; $3_p$, $3_n$), das an dem äußeren Drain-Anschluss (D*) der Verstärkeranordnung (3; $3_p$, $3_n$) erhalten wird, zu zumindest einem Gate-Anschluss (G) der Feldeffekttransistoren (MN; $MN_1$, $MN_3$; $MN_2$, $MN_4$) der Verstärkeranordnung (3; $3_p$, $3_n$), wobei die Rückkopplungsanordnung (4; $4_p$, $4_n$) zumindest eine passive oder aktive elektronische Komponente ($Z_b$; $Z_{bp}$, $Z_{bn}$; $R_{bp}$, $C_{bp}$, $R_{bn}$, $C_{bn}$) aufweist, die den äußeren Drain-Anschluss (D*) der Verstärkeranordnung (3; $3_p$, $3_n$) mit dem Gate-Anschluss (G) des Feldeffekttransistors (MN; $MN_1$, ($MN_3$); $MN_2$, ($MN_4$)) verbindet, der den äußeren Source-Anschluss (S*) aufweist; und
   eine erste Stromquelle (5; $5_p$, $5_n$) zum Vorspannen der Reihenschaltung des Feldeffekttransistors (MN; $MN_1$, $MN_3$; $MN_2$, $MN_4$), der den äußeren Source-Anschluss (S*) aufweist, und des variablen Widerstandes ($R_S$; $R_{Sp}$, $R_{Sn}$).

**2.** Eine Sensorschaltung gemäß dem vorhergehenden Anspruch, bei der die erste Stromquelle (5; $5_p$, $5_n$) zwischen der ersten Verstärkeranordnung (3; $3_p$, $3_n$) und einer ersten Spannungsversorgung ($V_{DD}$) angeordnet ist.

**3.** Eine Sensorschaltung gemäß einem der vorhergehenden Ansprüche, bei der die Erfassungszusammensetzung (2; $2_p$, $2_n$) zumindest eine zweite Verstärkeranordnung ($9_n$, $9_p$; $9'_n$, $9'_p$) aufweist, die dazu ausgebildet ist, das Ausgangssignal ($V_{out}$; $V_{outp}$, $V_{outn}$) der ersten Verstärkeranordnung (3; $3_p$, $3_n$) oder ein von dem Ausgangssignal ($V_{out}$; $V_{outp}$, $V_{outn}$) abgeleitetes Signal zu verstärken, um ein verstärktes Ausgangssignal ($V_{outpa}$, $V_{outna}$) zu erhalten.

**4.** Eine Sensorschaltung gemäß dem vorhergehenden Anspruch, bei der die zweite Verstärkeranordnung ($9_n$, $9_p$; $9'_n$, $9'_p$) als eine nicht invertierende Verstärkeranordnung ($9_n$, $9_p$) konzipiert ist.

**5.** Eine Sensorschaltung gemäß Anspruch 3, bei der die zweite Verstärkeranordnung ($9_n$, $9_p$; $9'_n$, $9'_p$) als eine invertierende Verstärkeranordnung ($9'_n$, $9'_p$) konzipiert ist.

**6.** Eine Sensorschaltung gemäß einem der vorhergehenden Ansprüche, bei der die Sensorschaltung (1) eine erste Erfassungszusammensetzung ($2_p$) und eine zweite Erfassungszusammensetzung ($2_n$) aufweist, die in einer differentiellen Konfiguration angeordnet sind.

**7.** Eine Sensorschaltung gemäß dem vorhergehenden Anspruch, bei der eine dritte Stromquelle (10) dazu ausgebildet ist, eine virtuelle Masse für die erste Erfassungszusammensetzung ($2_p$) und die zweite Erfassungszusammensetzung ($2_n$) zu schaffen.

**8.** Eine Sensorschaltung gemäß einem der vorhergehenden Ansprüche, bei der der variable Widerstand ($R_S$; $R_{Sp}$, $R_{Sn}$) dazu ausgebildet ist, eine modulierte Eingangsspannung ($V_{inp}$, $V_{inn}$) für die erste Verstärkeranordnung (3; $3_p$, $3_n$) zu erzeugen, und bei der das Ausgangssignal ($V_{outp}$, $V_{outn}$) der ersten Verstärkeranordnung (3; $3_p$, $3_n$) einem Mischer (MX) zum Abwärtsmischen des Ausgangssignals ($V_{outp}$, $V_{outn}$) zu Gleichstrom zugeführt wird.

**9.** Eine Sensorschaltung gemäß einem der vorhergehenden Ansprüche, bei der die Rückkopplungsanordnung (4; $4_p$, $4_n$) der ersten Verstärkeranordnung (3; $3_p$, $3_n$) derart konzipiert ist, dass die erste Verstärkeranordnung (3; $3_p$, $3_n$) eine Hochpassübertragungsfunktion aufweist.

**10.** Eine Sensorschaltung gemäß dem vorhergehenden Anspruch, bei der ein Ausgangssignal ($V_{outmp}$, $V_{outmn}$) des Mischers (MX) einer dritten Verstärkeranordnung ($11_p$, $11_n$) zugeführt wird, wobei eine Rückkopplungsanordnung ($12_p$, $12_n$) für die dritte Verstärkeranordnung ($11_p$, $11_n$) derart konzipiert ist, dass die dritte Verstärkeranordnung ($11_p$, $11_n$) eine Tiefpassübertragungsfunktion aufweist.

**11.** Eine Sensorschaltung gemäß dem vorhergehenden Anspruch, bei der die dritte Verstärkeranordnung (11 p, $11_n$) als ein vollständig differentieller Verstärker ($11_p$, $11_n$) konzipiert ist.

## Revendications

**1.** Circuit de détection destiné à mesurer une quantité physique,
dans lequel le circuit de détection (1) comprend au moins une composition de détection (2; $2_p$, $2_n$) comprenant:

une résistance variable ($R_S$; $R_{Sp}$, $R_{Sn}$) ayant une résistance fonction de la quantité physique;
un premier aménagement d'amplificateurs (3; $3_p$, $3_n$) destiné à sortir un signal de sortie ($V_{out}$; $V_{outp}$, $V_{outh}$) sur base de la résistance de la résistance variable ($R_s$; $R_{Sp}$, $R_{Sn}$), où le premier aménagement d'amplificateurs (3; $3_p$, $3_n$) comprend un transistor à effet de champ (MN) ou une pluralité de transistors à effet de champ ($MN_1$, $MN_3$; $MN_2$, $MN_4$) selon une configuration en cascode télescopique ou une pluralité de transistors à effet de champ ($MN_1$, $MP_3$; $MN_2$, $MP_4$) selon une configuration en cascode repliée, où le premier aménagement d'amplificateurs (3; $3_p$, $3_n$) comprend une borne de source extérieure (S*) et une borne de drain extérieure (D*), où une première borne de la résistance variable ($R_S$; $R_{Sp}$, $R_{Sn}$) est reliée à la borne de source extérieure (S*) du premier aménagement d'amplificateurs (3; $3_p$, $3_n$), de sorte que le transistor à effet de champ (MN; $MN_1$; $MN_2$) présentant la borne de source extérieure (S*) et la résistance variable ($R_S$; $R_{Sp}$, $R_{Sn}$) forment un circuit série;
un aménagement de rétroaction (4; $4_p$, $4_n$) destiné à rétro-alimenter au moins une partie du signal de sortie ($V_{out}$; $V_{outp}$, $V_{outn}$) du premier aménagement d'amplificateurs (3; $3_p$, $3_n$), qui est obtenu à la borne de drain extérieure (D*) de l'aménagement d'amplificateurs (3; $3_p$, $3_n$), vers au moins une borne de grille (G) des transistors à effet de champ ($MN$; $MN_1$, $MN_3$; $MN_2$, $MN_4$) de l'aménagement d'amplificateurs (3; $3_p$, $3_n$), où l'aménagement de rétroaction (4; $4_n$) comprend au moins un composant électronique passif ou actif ($Z_b$; $Z_{bp}$, $Z_{bn}$; $R_{bp}$, $C_{bp}$, $R_{bn}$, $C_{bn}$) qui relie la borne de drain extérieure ($D^*$) de l'aménagement d'amplificateurs (3; $3_p$, $3_n$) à la borne de grille ($G$) du transistor à effet de champ ($MN$; $MN_1$, ($MN_3$); $MN_2$, ($MN_4$)) présentant la borne de source extérieure ($S^*$); et

une première source de courant (5; $5_p$, $5_n$) destinée à polariser le circuit série du transistor à effet de champ ($MN$; $MN_1$, $MN_3$; $MN_2$, $MN_4$) présentant la borne de source extérieure ($S^*$) et la résistance variable, ($R_S$; $R_{Sp}$, $R_{Sn}$).

**2.** Circuit de détection selon la revendication précédente, dans lequel la première source de courant (5; $5_p$, $5_n$) est disposée entre le premier aménagement d'amplificateurs (3; $3_p$, $3_n$) et une première alimentation de tension ($V_{DD}$).

**3.** Circuit de détection selon l'une des revendications précédentes, dans lequel la composition de détection (2; $2_p$, $2_n$) comprend au moins un deuxième aménagement d'amplificateurs ($9_n$, $9_p$; $9'_n$, $9'_p$) configuré pour amplifier le signal de sortie ($V_{out}$; $V_{outn}$) du premier aménagement d'amplificateurs (3; $3_p$, $3_n$) ou un signal dérivé du signal de sortie ($V_{out}$; $V_{outn}$), pour obtenir un signal de sortie amplifié ($V_{outpa}$, $V_{outna}$).

**4.** Circuit de détection selon la revendication précédente, dans lequel le deuxième aménagement d'amplificateurs ($9_n$, $9_p$; $9'_n$, $9'_p$) est conçu comme un aménagement d'amplificateurs sans inversion ($9_n$, $9_p$)·.

**5.** Circuit de détection selon la revendication 3, dans lequel le deuxième aménagement d'amplificateurs ($9_n$, $9_p$; $9'_n$, $9'_p$) est conçu comme un aménagement d'amplificateurs à inversion ($9'_n$, $9'_p$).

**6.** Circuit de détection selon l'une des revendications précédentes, dans lequel le circuit de détection (1) comprend une première composition de détection ($2_p$) et une deuxième composition de détection ($2_n$) qui sont disposées selon une configuration différentielle.

**7.** Circuit de détection selon la revendication précédente, dans lequel une troisième source de courant (10) est configurée pour créer une masse virtuelle pour la première composition de détection ($2_p$) et la deuxième composition de détection ($2_n$).

**8.** Circuit de détection selon l'une des revendications précédentes, dans lequel la résistance variable ($R_S$; $R_{Sp}$, $R_{Sn}$) est configurée pour générer une tension d'entrée modulée ($V_{inp}$, $V_{inn}$) pour le premier aménagement d'amplificateurs (3; $3_p$, $3_n$) et dans lequel le signal de sortie ($V_{outp}$, $V_{outn}$) du premier aménagement d'amplificateurs (3; $3_p$, $3_n$) est alimenté vers un mélangeur ($MX$) destiné à mélanger vers le bas le signal de sortie ($V_{outp}$, $V_{outn}$) vers le courant continu.

**9.** Circuit de détection selon l'une des revendications précédentes, dans lequel l'aménagement de rétroaction (4; $4_p$, $4_n$) du premier aménagement d'amplificateurs (3; $3_p$, $3_n$) est conçu de sorte que le premier aménagement d'amplificateurs (3; $3_p$, $3_n$) présente une fonction de transfert passe-haut.

**10.** Circuit de détection selon la revendication précédente, dans lequel un signal de sortie ($V_{outmp}$, $V_{outmn}$) du mélangeur ($MX$) est alimenté vers un troisième aménagement d'amplificateurs ($11_p$, $11_n$), dans lequel l'aménagement d'amplificateurs de rétroaction ($12_p$, $12_n$) du troisième aménagement d'amplificateurs ($11_p$, $11_n$) est conçu de sorte que le troisième aménagement d'amplificateurs ($11_p$, $11_n$) présente une fonction de transfert passe-bas.

**11.** Circuit de détection selon la revendication précédente, dans lequel le troisième aménagement d'amplificateurs ($11_p$, $11_n$) est conçu comme un amplificateur entièrement différentiel ($11_p$, $11_n$).

FIG 1A

FIG 1B

FIG 2A

FIG 2B

FIG 2C

FIG 2D

FIG 2E

EP 2 878 927 B1

FIG 2F

EP 2 878 927 B1

FIG 3

EP 2 878 927 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110248783 A1
- US 6724202 B2
- US 4786993 A
- US 7961418 B2

**Non-patent literature cited in the description**

- **WALT KESTER.** Practical design techniques for sensor signal conditioning. *Analog Devices,* 1999